Europäisches Patentamt

European Patent Office

Office européen des brevets

(19)

(11) **EP 1 353 437 A2**

(12) **EUROPÄISCHE PATENTANMELDUNG**

(43) Veröffentlichungstag:
**15.10.2003 Patentblatt 2003/42**

(51) Int Cl.7: **H03B 5/18**

(21) Anmeldenummer: **03007667.3**

(22) Anmeldetag: **03.04.2003**

(84) Benannte Vertragsstaaten:
**AT BE BG CH CY CZ DE DK EE ES FI FR GB GR HU IE IT LI LU MC NL PT SE SI SK TR**
Benannte Erstreckungsstaaten:
**AL LT LV MK RO SI**

(30) Priorität: **08.04.2002 DE 10215423**

(71) Anmelder: **InnoSenT GmbH**
**97499 Donnersdorf (DE)**

(72) Erfinder:
• **Lenhard, Thilo**
**96103 - Hallstadt (DE)**

• **Diefenbacher, Michael**
**97437 - Hassfurt (DE)**
• **Weidmann, Wolfgang**
**97359 - Schwarzach am Main (DE)**

(74) Vertreter: **Küchler, Stefan et al**
**Götz & Küchler**
**Patentanwälte,**
**Färberstrasse 20**
**90402 Nürnberg (DE)**

(54) **Mikrowellen-Oszillator**

(57) Die Erfindung richtet sich auf einen Mikrowellen-Oszillator mit einem Verstärkungselement, dessen Ausgangssignal über ein Rückkopplungsnetzwerk mit einer frequenzabhängigen Übertragungskennlinie zu seinem Eingang zurückgeführt ist, wobei die Zurückführung mittels zweier streifenartiger Mikrowellenleiter erfolgt, die auf einem Substrat angeordnet sind, wobei der eine Mikrowellenleiter an einem Eingangsanschluß des Verstärkungselements (Eingangs-Mikrowellenleiter) und der andere Mikrowellenleiter an einem Ausgangsanschluß desselben angeschlossen ist (Ausgangs-Mikrowellenleiter), und wobei das Rückkopplungsnetzwerk eine flächige Mikrowellenleiter-Struktur umfaßt, die zwischen dem Eingangs-Mikrowellenleiter und dem Ausgangs-Mikrowellenleiter eingefügt ist und eine maximale Ausdehnung aufweist, die insbesondere kürzer ist als die Gesamtlänge des Eingangs-Mikrowellenleiters und insbesondere auch kürzer als die Gesamtlänge des Ausgangs-Mikrowellenleiters.

EP 1 353 437 A2

**Beschreibung**

Die Erfindung richtet sich auf einen Mikrowellen-Oszillator mit einem Verstärkungselement, dessen Ausgangssignal über ein Rückkopplungsnetzwerk mit einer frequenzabhängigen Übertragungskennlinie zu seinem Eingang zurückgeführt ist.

Schaltungen, und damit insbesondere auch Oszillatoren für hochfrequente Schwingungen mit Wellenlängen im Mikrowellenbereich, erfordern eine besondere Konstruktion; zur Miniaturisierung werden Mikrostreifenleiter verwendet, um diskret aufgelötete Bauteile galvanisch miteinander zu verbinden. Mit dieser Technik bisher aufgebaute Mikrowellen-Oszillatoren enthalten als Rückkopplungsnetzwerk üblicherweise einen diskreten Resonator, der ein pillenförmiges Element aus einem artfremden Material mit einer sehr hohen Dielektrizitätszahl (> 20) aufweist (Dielectric Resonator stabilized Oscillator, DRO). Ein solcher, dielektrischer Resonator bringt als zusätzlich zu bestückendes Bauteil hohe Kosten mit sich (evtl. mehr als 10 % der Gesamtkosten des Mikrowellen-Oszillators), viel schwerer wiegt aber der wegen enger Toleranzen erhöhte Zeitaufwand bei der Plazierung dieses Elements auf der planaren Schaltung, da zumindest bei höheren Frequenzen (≥ 15 GHz) eine Automatisierung nicht möglich ist. Darüber hinaus sind solchermaßen aufgebaute Oszillatoren hinsichtlich ihrer Schwingfrequenz nur begrenzt verstellbar.

Eine gattungsgemäße Anordnung ist bspw. aus der deutschen Offenlegungsschrift 198 00 459 bekannt. Bei dieser Anordnung wird versucht, den oben beschriebenen Aufwand für die Herstellung des Resonators dadurch zu reduzieren, dass dieser als flächige Leiterstruktur konstruiert ist. Zwar kann dabei noch der Platzbedarf des eigentlichen Oszillator-Schaltkreises bzw. Verstärkerelements minimiert werden, indem der Resonator getrennt auf bzw. in dem Substrat realisiert ist. Gerade dieser Resonator ist jedoch flächenmäßig sehr groß, da er an beiden Längsseiten einer Leiter-Zunge große Masseanschlußflächen aufweist. Diese Masseanschlußflächen sollen der Abschirmung gegenüber äußeren Störfeldern dienen. Sie sind zwar beide mit der dazwischen liegenden Leiter-Zunge an einem Ende derselben galvanisch verbunden; da sie andererseits in der selben Ebene mit dieser Leiter-Zunge liegen, sind die einander gegenüberstehenden Oberflächen im übrigen jedoch minimal, mithin die Abschirmwirkung gering. Sie werden deshalb großflächig ausgelegt, und dadurch wird die gesamte Resonatoranordnung viel breiter als bspw. die Länge der als Leiter-Zunge ausgebildete Ein- oder Ausgangs-Leiterbahn selbst.

Hier kann auch die Lehre nach der deutschen Offenlegungsschrift 198 56 339 keine Abhilfe bringen. Daraus sind zwar miteinander gekoppelte Mikrowellen-Streifenleitungen bekannt; da diese jedoch galvanisch nicht miteinander gekoppelt sind, ist eine Übertragung dieser Struktur auf den Mikrowellen-Oszillator aus der zuerst erwähnten Offenlegungsschrift nicht möglich, weil dort eine galvanische Kopplung mit dem Massepotential erforderlich ist, die bei Mikrowellen-Streifenleitungen nicht gegeben ist.

Aus den Nachteilen des beschriebenen Stands der Technik resultiert das die Erfindung initiierende Problem, einen Mikrowellen-Oszillator zu schaffen, bei welchem der Resonator mit einfachsten Mitteln, geringstem Arbeitsaufwand und auch so platzsparend als möglich realisiert werden kann.

Die Lösung dieses Problems gelingt mit der folgenden Anordnung:

a) die Zurückführung erfolgt mittels zweier streifenartiger Mikrowellenleiter, die auf einem Substrat über einer leitenden (Masse-) Fläche angeordnet sind, wobei der eine Mikrowellenleiter an einem Eingangsanschluß des Verstärkungselements (Eingangs-Mikrowellenleiter) und der andere Mikrowellenleiter an einem Ausgangsanschluß desselben angeschlossen ist (Ausgangs-Mikrowellenleiter), wobei

b) das Rückkopplungsnetzwerk eine flächige Mikrowellenleiter-Struktur umfaßt, die innerhalb einer Ebene zwischen dem Eingangs-Mikrowellenleiter und dem Ausgangs-Mikrowellenleiter eingefügt ist und eine maximale Ausdehnung aufweist, die insbesondere kürzer ist als der Eingangs-Mikrowellenleiter und auch kürzer als der Ausgangs-Mikrowellenleiter.

Durch diese zusammenwirkenden Maßnahmen wird es möglich, die Resonatorabmessungen klein gegenüber den Mikrowellenleitern zu machen, um das Verstärkerelement von dem Resonator räumlich zu entkoppeln und dadurch Oberschwingungen zu vermeiden. Im Gegensatz zu den bisherigen Anordnungen wird dabei das frequenzbestimmende Rückkopplungsnetzwerk nicht nur mit derselben Technologie realisiert wie die streifenförmigen Mikrowellenleiter selbst, sondern es wird auch direkt zwischen Eingangs- und Ausgangs-Mikrowellenleiter eingefügt und tritt dadurch mit diesen in eine direkte und intensive Wechselwirkung. Aufgrund dieser starken bzw. relativ harten Verkopplung ist eine zusätzliche Abschirmung nicht erforderlich, und aus diesem Grunde können periphere Masseanschlußflächen entfallen. Das Ergebnis ist ein flächenmäßig viel kleinerer Resonator.

Erfindungsgemäß verlaufen dabei der Eingangs- und der Ausgangs-Mikrowellenleiter direkt neben, d.h. entlang zweier gegenüberliegender Längsseiten der mittleren, flächigen Mikrowellenleiter-Struktur, und zwar über (nahezu) die gesamte Länge dieser beiden Längsseiten. Lediglich ein der Abstimmung dienender Endabschnitt von höchstens etwa 10 %, vorzugsweise weniger als 5 %, insbesondere weniger als 2 % der Länge dieser Längsseiten kann evtl. zu Trimmungszwecken zunächst über den Überlappungsbereich hinaus verlängert sein. Demnach gibt es bei der Erfindung in dem hauptsächlichen Bereich der mittleren, flächigen Mikrowellenleiter-Struktur drei direkt nebeneinander verlaufende Mikrowellenleiter-Strukturen, und jeder in diesem Bereich quer zu der Längserstreckung einer bzw. aller Mikrowellenleiter-Strukturen gelegte Querschnitt durchsetzt alle drei Mikrowellenleiter. Dabei sollte der Abstand zwischen zwei benachbarten Mikrowellenleitern kleiner sein als die Breite w einer der drei Mikrowellenleiter-Strukturen, d.h., der Breite w der mittleren oder einer der beiden äußeren Mikrowellenleiter-Strukturen, während der Abstand der beiden äußeren der drei Mikrowellenleiter-Strukturen zu den übrigen Mikrowellenleiter-Strukturen innerhalb derselben Ebene größer sein sollte als ihre Breite w.

Als Trägersubstrat für den Resonator und/oder für die Mikrowellenleiter kann ein weiches Material Verwendung finden, bspw. Kunststoff, Teflon od. dgl., aber auch ein vergleichsweise harter Werkstoff, bspw. Aluminiumoxid-Keramik, LTCC (Low Temperature Cofired Ceramic), etc. Wichtig ist vielmehr ein ausreichendes elektrisches Isolationsvermögen und eine ausreichende mechanische Stabilität, damit größere Verformungen, welche zum Reißen aufgeschichteter Leiterbahnen führen könnten, vermieden werden.

Die streifenartigen Mikrowellenleiter haben vorzugsweise die Struktur einer Streifenleitung, einer Mikrostreifenleitung, einer Triplate-Leitung, und/oder einer Koplanar-Leitung. Derartige Strukturen bilden ein dreidimensional nicht eingegrenztes, elektromagnetisches Feld aus und erlauben daher eine einfache Verkopplung über dieses Feld, wenn sie in enger Nachbarschaft verlegt sind.

Es hat sich als günstig erwiesen, dass die mittlere, flächige Mikrowellenleiter-Struktur in Längsrichtung eines oder beider gekoppelter Mikrowellenleiter eine Erstreckung 12 in der Größenordnung etwa der halben Wellenlänge $\lambda/2$ der zu erzeugenden Schwingungsfrequenz hat ($l_2 \approx \lambda/2$). Dadurch wird innerhalb dieser Struktur eine stehende Welle mit der gewünschten Frequenz angeregt, so dass eine verlustarme Rückkopplung erfolgt. Da Schwingungen mit anderen Wellenlängen vergleichsweise stark bedämpft werden, ergibt sich eine hohe Konstanz der betreffenden Schwingung.

Es liegt im Rahmen der Erfindung, dass die mittlere, flächige Mikrowellenleiter-Struktur überwiegend durch gerade Längsseiten begrenzt wird. Damit ist es möglich, diese ohne Modifikation des Ein- und Ausgangs-Mikrowellenleiters nahe an dieselben heranzurücken und dadurch eine intensive Ankopplung zu erreichen.

Indem die mittlere, flächige Mikrowellenleiter-Struktur überwiegend durch zueinander parallele Längsseiten begrenzt wird, sind die Ausbreitungsrichtungen der ein- und ausgekoppelten Wellen parallel zueinander. Dadurch ergeben sich einfache elektromagnetische Verhältnisse, die eine Modellbildung bspw. für eine Simulationsrechnung begünstigen.

Wenn die Breite der mittleren, flächigen Mikrowellenleiter-Struktur etwa der Breite w des Ein- und/oder Ausgangs-Mikrowellenleiters entspricht, hat sie denselben Wellenwiderstand wie der Ein- und Ausgangs-Mikrowellenleiter, so dass eine optimale, reflexionsfreie Verkopplung des Resonators mit den betreffenden Mikrowellenleitern möglich ist.

Weitere Vorteile lassen sich erzielen, indem die mittlere, flächige Mikrowellenleiter-Struktur mit dem Ein- und/oder Ausgangs-Mikrowellenleiter galvanisch verbunden ist. Eine derartige Ankopplung kann als "hart" bezeichnet werden, d.h., die Amplituden- und Phasenverhältnisse in dem solchermaßen angekoppelten Mikrowellenleiter sind ähnlich den Verhältnissen in der mittleren, flächigen Mikrowellenleiter-Struktur. Demzufolge kann über eine derartige Ankopplung eine optimale Synchronität zwischen diesen Elementen erreicht werden, und dadurch kann die mittlere Mikrowellenleiter-Struktur starken Einfluß auf die Frequenz der Schwingung ausüben.

Die galvanische Verbindung sollte sich nur über etwa 1/8 bis ½ der Längserstreckung der mittleren, flächigen Mikrowellenleiter-Struktur erstrecken, vorzugsweise über etwa 1/6 bis 1/3 dieser Längserstreckung, insbesondere über etwa ¼ dieser Längserstreckung. Dadurch ergibt sich eine punktuelle Anregung bzw. Aus- oder Einkopplung, welche eine harmonische Schwingung bzw. Wellenausbreitung in der mittleren Mikrowellen-Struktur nur wenig stört, so dass diese ähnlich der Unruh einer Uhr ihren gleichmäßigen Schwingungsrhythmus beibehalten und sogar dem Oszillator aufprägen kann.

Um die beiden Schwingungsknoten der mittleren, flächigen Mikrowellenleiter-Struktur potentialmäßig von der verbundenen Eingangs- oder Ausgangsleitung zu trennen, sind die Schmalseiten des mittleren Mikrowellenleiters nirgends verbunden, und die seitliche galvanische Verbindung reicht bis an keine dieser Schmalseiten heran. Denn sonst müßte das gesamte Potential der mittleren Mikrowellenleiterstruktur die betreffende Schwingung nachvollziehen, was aufgrund der dabei umzuladenden Kapazitäten zu einer erheblichen Bedämpfung der Schwingungen in der gesamten Anordnung führen würde. Um diese Schwingungen nicht zu beeinträchtigen, sollte auch eine Trimmung bspw. durch Weglasern eines Teils der mittleren Mikrowellenleiterstruktur nicht an der der galvanischen Verbindung näherliegenden Schmalseite, sondern an der gegenüberliegenden Schmalseite erfolgen.

Bei der erfindungsgemäßen Bemessung der mittleren, flächigen Mikrowellenleiter-Struktur bildet sich in dieser eine stehende Welle aus, wobei die Schwingungsamplituden der elektrischen und/oder magnetischen Feldstärke etwa in der Mitte dieser Struktur maximal, an deren Enden dagegen minimal sind. Da die maximale Energie sich an den Orten der maximalen Feldstärkeamplituden befindet, so kann der Einfluß der Ankopplung auf die Schwingungsenergie begrenzt werden, indem die galvanische Verbindung etwa bei ¼ der Länge der mittleren, flächigen Mikrowellenleiter-Struktur vorgesehen wird. Durch eine derartige Positionierung der galvanischen Verbindung werden plötzliche Änderungen des Schwingungszustandes vermieden, die Schwingung ist sehr harmonisch.

Es hat sich bewährt, dass die Breite der Schlitze zwischen den miteinander gekoppelten Mikrowellenleiter-Strukturen etwa 1/8 bis ½ der Breite w der Mikrowellenleiter entspricht, vorzugsweise etwa 1/6 bis 1/3 dieser Leiterbreite w, insbesondere etwa ¼ dieser Leiterbreite w. Bei einer derartigen Bemessung ist einerseits noch eine vergleichsweise starke Verkopplung gegeben, andererseits lassen sich solche Strukturen zuverlässig mit herkömmlichen Techniken herstellen, bspw. durch Ätzen nach Aufdrucken des gewünschten Musters auf ein Platinen-Substrat.

Die Summe der Länge $l_1$ des Eingangs-Mikrowellenleiters und der Länge $l_3$ des Ausgangs-Mikrowellenleiters, jeweils zwischen dem betreffenden Anschluß des Verstärkungselements und des Rückkopplungsnetzwerks, sollte derart bemessen werden, dass für die Phasenverschiebung $\alpha$ in der Verstärkungsschaltung bzw. Verstärkerbaugruppe, die Phasenverschiebung $\beta$ in dem Rückkopplungsnetzwerk und die Phasenlaufzeit $\delta_1 + \delta_3$ auf der Ausgangs- und der Eingangsleitung gilt:

$$\alpha + \beta + \delta_1 + \delta_3 = 2 * k * \Pi; (k \in N)$$

Wird die gesamte Phasenverschiebung eines Signals innerhalb der über den erfindungsgemäßen Resonator zurückgekoppelten Schleife betrachtet, so muß diese 0, 2 * π, oder ein Vielfaches davon sein, damit eine Mitkopplung entsteht, die eine Schwingung ermöglicht. Je nach der Beschaltung des Verstärkerelements kann dieses eine signalinvertierende Wirkung entfalten wie bspw. bei einem Transistor in Emitterschaltung. Solchenfalls muß die Summe der übrigen, phasenverschiebenden Einflüsse (Resonator und Mikrowellenleiter) etwa eine Phasenverschiebung von π, 3 * π od. dgl. herbeiführen, um der Schwingbedigung zu genügen.

Besonders vorteilhafte Ergebnisse lassen sich erzielen, wenn die Summe der Länge $l_1$ des Eingangs-Mikrowellenleiters und der Länge $l_3$ des Ausgangs-Mikrowellenleiters, jeweils zwischen dem betreffenden Anschluß des Verstärkungselements und des Rückkopplungsnetzwerks, etwa gemäß folgender Formel bemessen ist:

$$l_1 + l_3 \approx k*l_2; (k \in N)$$

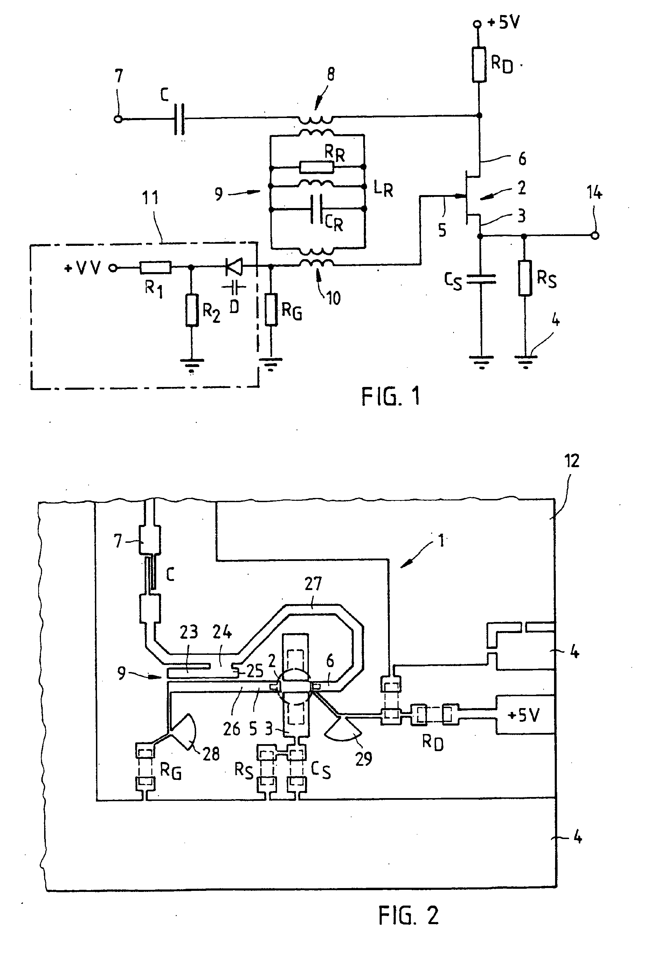

Bei Verwendung eines "schnellen" Verstärkerelements kann dessen Phasenverschiebung gegenüber der ggf. invertierenden Eigenschaft seiner Beschaltung vernachlässigt werden ($\alpha \approx 0$ oder $\alpha \approx \pi$). Faßt man den erfindungsgemäßen Doppelkoppler entsprechend seinem Ersatzschaltbild in Fig. 1 als Serienschaltung von zwei in Resonanz schwingenden Bandfiltern auf, welche jeweils einer Ankopplung der mittleren, flächigen Mikrowellen-Struktur entsprechen, so hat jeder dieser beiden Bandfilter eine Phasenverschiebung $\beta_1$, $\beta_2$ von jeweils 90°, so dass der Doppelkoppler insgesamt etwa eine Phasenverschiebung $\beta = \beta_1 + \beta_2$ von 180° verursacht.

In dem Fall einer invertierenden Verstärkerbeschaltung gilt demnach:

$$\alpha + \beta \approx 2 * \pi.$$

Demnach erfordert die Schwingbedingung noch

$$\delta_1 + \delta_3 \approx 2*k*\pi.$$

Dies trifft zu bei

$$l_1 + l_3 \approx k*\lambda \approx 2*k*l_2.$$

In dem Fall einer nicht invertierenden Verstärkerbeschaltung gilt:

$$\alpha + \beta \approx \pi.$$

Demnach erfordert die Schwingbedingung noch

$$\delta_1 + \delta_3 \approx (2*k + 1)*\pi.$$

Dies trifft zu bei

$$l_1 + l_3 \approx (2*k + 1)*\lambda/2 \approx (2*k + 1)*l_2.$$

Um die Schwingungsfrequenz f abzustimmen, kann die Längserstreckung $l_2$ der mittleren Mikrowellenleiter-Struktur verändert werden, bspw. durch Trimmen mittels eines Schneidmittels. Durch diese Maßnahme wird die Resonanzfrequenz der mittleren, flächigen Mikrowellen-Struktur und damit die Resonanzfrequenz beider Bandfilter verändert.

Andererseits ist es auch möglich, den Eingangs-Mikrowellenleiter jenseits des Rückkopplungsnetzwerks zu beeinflussen, um einen ähnlichen Effekt zu erzielen. Dadurch läßt sich insbesondere die Resonanzfrequenz des zweiten Bandpasses beeinflussen.

Eine derartige Abstimmung der Schwingungsfrequenz f ist bspw. dadurch möglich, dass die Länge des Eingangs-Mikrowellenleiters jenseits des Rückkopplungsnetzwerks, bzw. dessen Gesamtlänge $l_2 + l_3$, beeinflußbar ist, bspw. durch Trimmen mittels eines Schneidmittels. Zu diesem Zweck kann der Eingangs-Mikrowellenleiter zunächst über den Resonator (dessen mittlere Struktur) hinaus verlängert sein, bspw. um etwa 1 bis 5 mm. Dieser Bereich wirkt aufgrund der unter dem Substrat angeordneten Massefläche wie eine Kapazität, die das Schwingverhalten beeinflußt. Durch Veränderung der über den Resonator überstehenden Fläche kann diese Kapazität und damit auch die Schwingfrequenz des Mikrowellen-Oszillators verändert werden.

Eine andere Abstimmungsmöglichkeit umfaßt ein frequenzbestimmendes Bauteil, bspw. eine Kapazitätsdiode D, welches an dem Eingangs-Mikrowellenleiter jenseits des Rückkopplungsnetzwerks angekoppelt ist. Da eine solche Kapazität für hohe Frequenzen als dem Ausgang des zweiten Bandfilters parallel geschaltet zu betrachten ist, verändert sie dessen Resonanzfrequenz, bei welcher dessen Phasenverschiebung $\beta_2$ wieder 90° beträgt. Demnach ist die Schwingungsbedingung nun bei einer neuen, mittleren Resonanzfrequenz erfüllt, wo wieder gilt:

$$\beta_1 + \beta_2 = \beta = 180°.$$

Indem der Eingangs-Mikrowellenleiter gleichspannungsmäßig mit DC-Masse gekoppelt ist, insbesondere über einen Widerstand $R_G$, erfolgt eine Bedämpfung der Oszillator-Schleife, so dass evtl. neben der Resonanzfrequenz noch angeregte Schwingungsanteile anderer Frequenzen kurzgeschlossen und dadurch unterdrückt werden.

Vorzugsweise ist das Verstärkungselement ein Halbleiterbauelement. Derartige Verstärkungselemente lassen sich auf einem weitaus kleineren Raum realisieren als bspw. Röhren, und sie können letztere daher bei kleinen und mittleren Sendeleistungen ersetzen. Als Verstärkungs-Halbleiterbauteile kommen bspw. Gunn- oder Impatt-Dioden in Frage. Bevorzugt wird jedoch ein Transistor, vorzugsweise ein Hoch- oder Höchstfrequenztransistor, insbesondere ein Bipolar- oder Feldeffekttransistor. Besonders geeignete Bauformen sind GaAs-MESFETs, PHEMTs, SiGe, HBTs, etc.

Die Erfindung empfiehlt, einen Transistor in Emitter- bzw. Sourceschaltung zu betreiben, wobei der Basis- bzw. Gateanschluß als Eingang und der Kollektor- bzw. Drainanschluß als Ausgang dient. Dies hat den Vorteil einer großen Spannungsverstärkung bei gleichzeitig (sehr) hohem Eingangswiderstand, so dass die über den Resonator einzukoppelnde Leistung nur vergleichsweise gering zu sein braucht.

Zur Einstellung des Arbeitspunktes eines Feldeffekttransistors kann an dem Sourceanschluß eine Gegenkopplungsimpedanz nach DC-Masse angeschlossen sein, bspw. ein Gegenkopplungswiderstand $R_S$ und/oder eine Gegenkopplungskapazität $C_S$. Einerseits können durch eine derartige Stromgegenkopplung Verzerrungen in dem Verstärker vermindert werden. Viel wichtiger ist bei einem Feldeffekttransistor jedoch die Erzeugung eines negativeren Potentials an dem Gate gegenüber dem Sourceanschluß ohne Verwendung einer negativen Hilfsspannung. Durch den Spannungsabfall an $R_S$ steigt das Sourcepotential, wodurch die gewünschte Spannungsdifferenz eingestellt werden kann. Eine parallelgeschaltete Kapazität $C_S$ kann dabei insbesondere während Phasen mit niedrigem Sourcestrom dieses Sannungspotential stabilisieren.

Schließlich entspricht es der Lehre der Erfindung, dass die Gegenkopplungskapazität $C_S$ eine großflächige Leiterfläche umfaßt, die sich in geringem Abstand parallel zu einer Massepotential führenden Leiterbahnebene erstreckt (Multilayer-Anordnung) und galvanisch mit dem Sourceanschluß verbunden ist. Zusammen mit einer (darunter liegenden) ebenfalls großflächigen Masse-Ebene ergeben sich somit zwei Platten eines Kondensators, die für eine hohe Konstanz des Hilfspotentials an dem Transistor-Source-Anschluß sorgen. Gleichzeitig steht diese Hochfrequenz-Hilfs-Masse insbesondere für auf der Substratoberseite verlegte Streifenleitungen als Gegenpol zur Verfügung und bildet damit die eigentliche Hochfrequenz-Masse.

Weitere Merkmale, Einzelheiten, Vorteile und Wirkungen ergeben sich aus der folgenden Beschreibung bevorzugter Ausführungsformen der Erfindung sowie anhand der Zeichnung. Hierbei zeigt:

Fig. 1    ein Ersatzschaltbild eines erfindungsgemäßen Mikrowellen-Oszillators;

Fig. 2    ein Layout als konkrete Realisierungsmöglichkeit der Schaltung aus Fig. 1;

Fig. 3    einen Querschnitt durch den Oszillator aus Fig. 2; sowie

Fig. 4    eine der Fig. 2 entsprechende Darstellung einer abgewandelten Ausführungsform der Erfindung.

Fig. 1 ist das Grundprinzip des erfindungsgemäßen Mikrowellen-Oszillators 1 zu entnehmen. Als Verstärkungselement dient ein Feldeffekttransoistor 2, der in Sourceschaltung betrieben wird. Dies bedeutet, dass der Sourceanschluß 3 über eine Sourceimpedanz, bestehend aus einem Sourcewiderstand $R_S$ und einer parallelgeschalteten Sourcekapazität $C_S$, mit der allgemeinen Schaltungsmasse 4 verbunden ist.

Als Eingangsanschluß des Feldeffekttransistors 2 dient dessen Gate 5, als Ausgangsanschluß sein Drainanschluß 6, der zu diesem Zweck über einen Drainwiderstand $R_D$ mit der positiven Versorgungsspannung (+5V) verbunden ist. Da bei einem Anstieg der Gatespannung der Drainstrom ansteigt und aufgrund des Spannungsabfalls an RD die abgegriffene Drainspannung 6 absinkt, hat die Verstärkerschaltung 2 - 6 signalinvertierende Eigenschaften. Bei Verwendung eines schnellen Hochfrequenztransistors 2 kann daher das Ausgangssignal 6 gegenüber dem Eingangssignal 5 um etwa 180° phasenverschoben sein (Phasenwinkel $\alpha \approx 180°$).

Das Transistorausgangssignal 6 kann einerseits über eine Koppelkapazität C potentialfrei abgegriffen und über den Anschluß 7 weiteren Schaltungsteilen zugeführt werden. Andererseits wird ein Teil des Ausgangssignals ausgekoppelt 8 und einem Resonator 9 zugeführt. Für diesen wurde als Ersatzschaltung das Symbol eines bedämpften Schwingkreises gewählt mit $L_R$, $C_R$ und $R_R$. Von diesem Schwingkreis wird wiederum ein Anteil ausgekoppelt 10 und über das Gate 5 unter Schließung der Rückkopplungsschleife dem Feldeffekttransistor 2 zugeführt.

Jenseits des Resonators 9 ist an der Eingangsleitung 5 ein Gatewiderstand $R_G$ nach Masse 4 angeschlossen. Mit diesem wird das Gatepotential im Arbeitspunkt auf Masse 4 gezogen.

Wie das Ersatzschaltbild weiter zeigt, sind im Rahmen des Resonators 9 zwei Kopplungen 8, 10 vorgesehen. Aufgrund der Kapazität $C_R$ sowie weiterer, unvermeidlicher Streukapazitäten an der Eingangs- bzw. Ausgangsleitung 5, 6 kann jede dieser Kopplungen 8, 10 als Bandfilter angesehen werden, der jeweils bei Resonanz eine Phasenverschiebung $\beta_1 = \beta_2 = 90°$ aufweist. Die gesamte Resonatorstruktur produziert daher bei Resonanz eine Phasenverschiebung von $\beta = 180°$. Die Resonanzfrequenz und damit die Schwingungsfrequenz des Mikrowellen-Oszillators 1 ist dabei primär bestimmt durch die Schwingkreiselemente $L_R$ und $C_R$.

Um die Schwingungsfrequenz des Mikrowellen-Oszillators 1 beeinflussen zu können, kann an die Eingangsleitung 5 in dem Bereich zwischen dem Koppler 10 und dem Gatewiderstand $R_G$ eine (einstellbare) Kapazität angeschlossen sein. Zu diesem Zweck kann insbesondere eine Kapazitätsdiode D verwendet werden, deren Kapazität durch Variation einer Versorgungsspannung +VV verstellbar ist, um den Oszillator innerhalb vorgegebener Grenzen durchstimmen zu können. Die Einstellspannung +VV kann dem Kathodenanschluß der Diode D über einen Spannungsteiler $R_1$, $R_2$ zugeführt werden. Dieser Schaltungsblock ist jedoch optional und kann bei einem Festfrequenzoszillator entfallen; er ist deshalb in Fig. 1 durch eine strichpunktierte Umrandung 11 gekennzeichnet.

Dementsprechend zeigt Bild 2 als Grundform des erfindungsgemäßen Mikrowellen-Oszillators 1 das Layout für die Schaltung aus Fig. 1, jedoch ohne den Schaltungsblock 11. Diese Platine 12 ist für eine Bestückung mit einseitig aufzulötenden SMD-Bauteilen (surface mount devices) konzipiert, wobei aufzulötende, diskrete Bauteile strichpunktiert eingezeichnet und mit den Bezeichnungen aus Fig. 1 versehen sind.

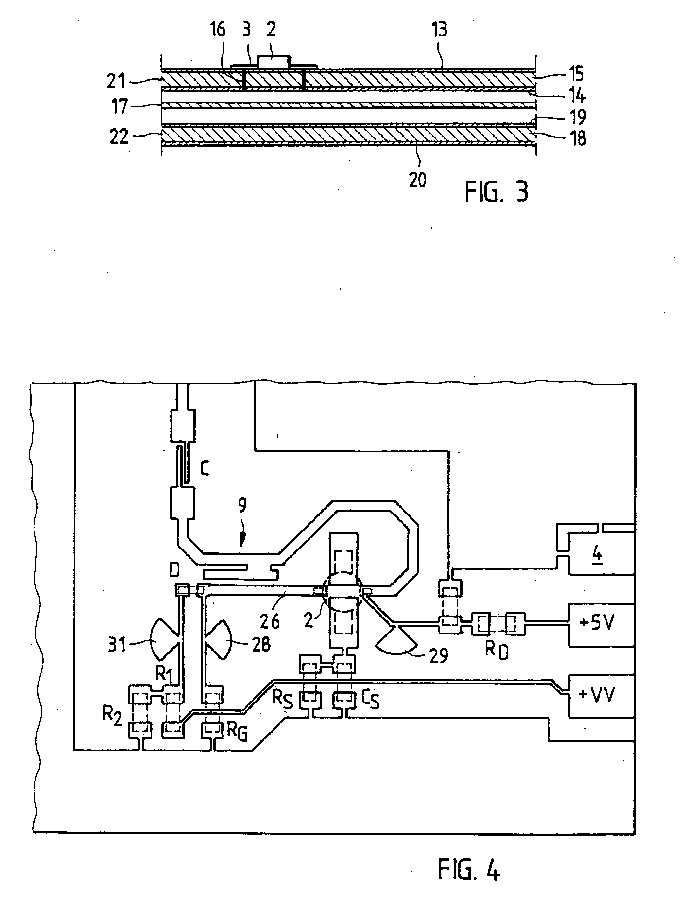

Man erkennt, dass die das hochfrequente Ein-/Ausgangssignal führenden Leiterbahnen 5, 6, 7 als Mikrostreifenleiter ausgebildet sind. Dabei wirken die auf der Oberseite 13 der Platine 12 aufgebrachten Leiterbahnen 5, 6, 7 zusammen mit einer darunter verlegten Massefläche 14, die von der Oberseite 13 durch ein elektrisch isolierendes Substrat 15 getrennt ist. Dies geht deutlicher aus der Schnittdarstellung nach Fig. 3 hervor. Wie man aus den Durchkontaktierungen 16 aus Fig. 3 weiter ersehen kann, ist diese HF-Massefläche 14 mit dem Sourceanschluß 3 des Feldeffekttransistors 2 elektrisch leitend verbunden.

Unterhalb der HF-Massefläche 14 und von dieser durch weitere Substratschichten 17, 18 getrennt können weitere Potentialschichten 19, 20 vorgesehen sein, bspw. (von oben nach unten) für die Gleichspannungsmasse 4 und das Potential der positiven Versorgungsspannung +5V. Die Platine 12 kann bspw. durch Ätzen zweier beidseitig beschichteter Einzelplatinen 21, 22 und Zusammenkleben derselben unter Einfügen einer isolierenden Zwischenlage 17 hergestellt werden.

Aus alledem ergibt sich, dass das Bezugspotential für die Mikrostreifenleiter 5, 6, 7 die direkt unterhalb der Schaltung 1, 13 verlegte Hochfrequenzmasse 3, 14 ist.

Die Breite w der Mikrowellen-Streifenleiter 5, 6, 7 richtet sich nach den Eigenschaften des Substrats 15, insbesondere dessen effektiver Dielektrizitätskonstante $\varepsilon_{r,eff}$, nach dessen Dicke d und nach dem angestrebten Wellenwiderstand $Z_L$. Im allgemeinen gilt: $Z_L \approx Z_0 / (\varepsilon_{r,eff} * w/h)^{1/2}$ mit $Z_0$ = Wellenwiderstand des freien Raums.

Wie man Fig. 2 entnehmen kann, umfaßt der Resonator 9 eine gerade gestreckte Mikrowellen-Leiterbahn-Struktur 23, deren Breite w etwa der Breite w der Mikrowellen-Streifenleiter 5, 6, 7 entspricht. Die Länge $l_2$ dieser Mikrowellen-Leiterbahn-Struktur 23 entspricht etwa der halben Wellenlänge $\lambda/2$ der von dem Mikrowellen-Oszillator zu erzeugenden Schwingung, damit sich innerhalb dieser Struktur 23 eine stehende Welle ausbilden kann.

Die Mikrowellen-Leiterbahn-Struktur 23 verläuft parallel zu dem Eingangs-Mikrowellenleiter 5 und zu dem Ausgangs-Mikrowellenleiter 6 und zwar zwischen diesen, vorzugsweise mittig, d.h. mit gleichen Abständen. Diese Abstände bzw. Schlitzbreiten betragen nur einen Bruchteil der Leiterbahnbreite w, vorzugsweise weniger als deren Hälfte w/2, so dass sich eine gute Ankopplung über das elektromagnetische Feld ergibt. Andererseits sind diese Schlitzbreiten mindestens so groß gewählt, um im Rahmen üblicher Ätzverfahren eine zuverlässige galvanische Trennung herbeiführen zu können, bspw. (deutlich) größer als 100 µm. Mit Ausnahme von an den äußeren Mikrowellenleitern 5, 6 angeschlossenen Verbindungsleitungen weisen alle anderen Mikrowellenleiter-Strukturen, bspw. Filter 28, einen Abstand zu dem Resonator 9 auf, der größer ist als die Leiterbahnbreite w, vorzugsweise mindestens etwa die anderthalbfache Leiterbahnbreite (1,5 * w), insbesondere etwa die doppelte Leiterbahnbreite (2 * w). Dadurch werden Beeinträchtigungen der Schwingungen, insbesondere Verzerrungen derselben, d.h., die Ausbildung von Oberwellen, vermieden.

Um den Kopplungsgrad zu erhöhen, ist die mittlere Mikrowellen-Leiterbahn-Struktur 23 mit dem Ausgangs-Mikrowellenleiter 6 galvanisch verbunden 24. Die Verbindung 24 erstreckt sich über eine Länge von weniger als $I_2/2$, vorzugsweise über eine Länge von etwa $I_2/4$. Wie sich aus Fig. 2 ergibt, liegt diese Verbindung 24 unsymmetrisch zu einem Ende 25 der mittleren Mikrowellen-Leiterbahn-Struktur 23 hin verschoben, bspw. in einem Abstand von $I_2/8$ vor diesem Ende 25. Durch diese Maßnahme ergibt sich trotz moderater und technologisch beherrschbarer Schlitzbreiten eine intensive Rückkopplung über den Resonator 9 hinweg.

Der mittlere Verlauf der zu dem Gate 5 des Feldeffekttransistors 2 führenden Eingangs-Mikrowellen-Leiterbahn 26 hat die Gesamtlänge $I_3 + I_2$, und diese Leiterbahn 26 verläuft entlang einer Länge $I_2$ parallel zu der mittleren Mikrowellen-Leiterbahn-Struktur 23. Die Strecke des mittleren Verlaufs der zu dem Drain 6 des Feldeffektransistors 2 führenden Eingangs-Mikrowellen-Leiterbahn 27 von dem Ende 25 der mittleren Mikrowellen-Leiterbahn-Struktur 23 bis zu dem Drain 6 mißt $I_1$.

Gemäß den obigen Ausführungen hat die Verstärkerbeschaltung 2 - 6 signalinvertierende Eigenschaften, also etwa eine Phasenverschiebung von $\alpha \approx 180°$; die Resonatorstruktur 9 zusammen mit den Ankopplungen 8, 10 bei Resonanz ebenfalls $\beta = 180°$, also $\alpha + \beta \approx 360°$.

Um innerhalb der Rückkopplungsschleife die Schwingbedingung zu erfüllen, muß demnach die Summe der Phasenlaufzeiten $\delta_1$, $\delta_2$ auf den Mikrowellenleitungen 26, 27 ebenfalls etwa ein Vielfaches von $360°$ sein: $\delta = \delta_1 + \delta_2 \approx 360° (= 2 * \pi)$. Dies wird im Resonanzfall erreicht mit der Bemessung $I_1 + I_3 \approx k * \lambda \approx 2 * k * I_2$, wobei $\lambda$ die Wellenlänge der von dem Mikrowellen-Oszillator 1 zu erzeugenden Schwingung ist. Im vorliegenden Fall ist $k = 2$, also $I_1 + I_3 \approx 4 * I_2$. Natürlich können bedingt durch eine Phasennacheilung des Feldeffekttransistors 2 bei der Resonanzfrequenz Abweichungen von dieser Bemessungsregel auftreten, die ohne weiteres in der Größenordnung von $\lambda/10$ liegen oder sogar bis zu $\lambda/4$ betragen können.

Die etwa viertelkreisförmigen Mikrowellenstrukturen 28, 29 sind Saugfilter, welche die Oszillator-Schwingung auf den Mikrowellenleitungen 23 - 27 von dem Masseanschluß 4 und der Versorgungsspannug +5V fernhalten sollen. Für eine verbesserte Abschirmung des Mikrowellen-Oszillators 1 kann dieser innerhalb der Bestückungsebene zusätzlich von dem Massepotential 4 umgeben sein.

Das Layout der Platine 30 gemäß Fig. 4 unterscheidet sich von dem Layout der Platine 12 gemäß Fig. 2 nur durch die zusätzliche Realisierung des strichpunktiert umrandeten Blocks 11 aus Fig. 1, der eine Einflußnahme auf die Schwingungsfrequenz des Mikrowellen-Oszillators 1 ermöglicht.

Zu diesem Zweck ist an dem freien Ende des Eingangs-Mikrowellenleiters 26 jenseits des Resonators 9 eine Kapazitätsdiode D angeschlossen, deren zweiter Anschluß über einen Widerstands-Spannungs-teiler $R_1$, $R_2$ zum Masseanschluß 4 von einer variablen Spannung +VV angesteuert werden kann, um die Diodenspannung und damit deren Kapazität $C_D$ zu verstellen. Durch diese zusätzliche Kapazität $C_D$ wird der Resonator 9 bzw. dessen Ankopplung 10 an die Mikrowellenleitung 26 verstimmt. Auch hier ist ein Saugfilter 31 vorgesehen, um die Oszillationsschwingung von der Steuerspannung +VV und von der Masse 4 fernzuhalten.

**Patentansprüche**

1. Mikrowellen-Oszillator (1) mit einem Verstärkungselement (2), dessen Ausgangssignal (6) über ein Rückkopplungsnetzwerk (9) mit einer frequenzabhängigen Übertragungskennlinie zu seinem Eingang (5) zurückgeführt ist, **dadurch gekennzeichnet, daß**

   a) die Zurückführung mittels zweier streifenartiger Mikrowellenleiter erfolgt (26, 27), die auf einem Substrat (15) angeordnet sind, wobei der eine Mikrowellenleiter (26) an einem Eingangsanschluß (5) des Verstärkungselements (2; Eingangs-Mikrowellenleiter) und der andere Mikrowellenleiter (27) an einem Ausgangsanschluß (6) desselben angeschlossen ist (Ausgangs-Mikrowellenleiter), wobei
   b) das Rückkopplungsnetzwerk (9) eine flächige Mikrowellenleiter-Struktur (23) umfaßt, die zwischen dem Eingangs-Mikrowellenleiter (26) und dem Ausgangs-Mikrowellenleiter (27) eingefügt ist und eine maximale Ausdehnung aufweist, die insbesondere kürzer ist als die Gesamtlänge des Eingangs-Mikrowellenleiters (26) und insbesondere auch kürzer als die Gesamtlänge des Ausgangs-Mikrowellenleiters (27) (jeweils der zusammenhängenden Leiterbahn).

2. Mikrowellen-Oszillator nach Anspruch 1, **dadurch gekennzeichnet, dass** das Trägersubstrat (15) für den Resonator (9) und/oder für die Mikrowellenleiter (26, 27) aus einem weichen Werkstoff gefertigt ist, bspw. aus Kunststoff, Teflon od. dgl., oder aus einem harten, vorzugsweise keramischen Material, bspw. Aluminiumoxid-Keramik, LTCC (Low Temperature Cofired Ceramic, etc.

3. Mikrowellen-Oszillator nach Anspruch 1 oder 2, **dadurch gekennzeichnet, dass** die streifenartigen Mikrowellenleiter (26, 27) die Struktur einer Streifenleitung, einer Mikrostreifenleitung, einer Triplate-Leitung und/oder einer Koplanar-Leitung haben.

**4.** Mikrowellen-Oszillator nach einem der Ansprüche 1 bis 3, **dadurch gekennzeichnet, daß** die mittlere Mikrowellenleiter-Struktur (23) in der betreffenden (lokalen) Längsrichtung eines oder beider gekoppelter Mikrowellenleiter (26, 27) eine Erstreckung $l_2$ in der Größenordnung etwa der halben Wellenlänge $\lambda/2$ der zu erzeugenden Schwingungsfrequenz hat ($l_2 \approx \lambda/2$).

**5.** Mikrowellen-Oszillator nach einem der vorhergehenden Ansprüche, **dadurch gekennzeichnet, daß** die mittlere Mikrowellenleiter-Struktur (23) überwiegend durch gerade Längsseiten begrenzt wird.

**6.** Mikrowellen-Oszillator nach Anspruch 5, **dadurch gekennzeichnet, daß** die mittlere Mikrowellenleiter-Struktur (23) überwiegend durch zueinander parallele Längsseiten begrenzt wird.

**7.** Mikrowellen-Oszillator nach einem der vorhergehenden Ansprüche, **dadurch gekennzeichnet, daß** die mittlere Mikrowellenleiter-Struktur (23) mit dem Einund/oder Ausgangs-Mikrowellenleiter (26, 27) galvanisch verbunden ist (24).

**8.** Mikrowellen-Oszillator nach Anspruch 7, **dadurch gekennzeichnet, daß** die galvanische Verbindung (24) sich nur über etwa 1/8 bis ½ der Längserstreckung der mittleren Mikrowellenleiter-Struktur (23) erstreckt, vorzugsweise über etwa 1/6 bis 1/3 dieser Längserstreckung, insbesondere über etwa ¼ dieser Längserstreckung.

**9.** Mikrowellen-Oszillator nach einem der vorhergehenden Ansprüche, **dadurch gekennzeichnet, daß** die Längserstreckung $l_2$ der mittleren Mikrowellenleiter-Struktur (23) beeinflußbar ist, um die Schwingungsfrequenz f abzustimmen, bspw. mittels eines Schneidmittels trimmbar.

**10.** Mikrowellen-Oszillator nach einem der vorhergehenden Ansprüche, **dadurch gekennzeichnet, daß** der Eingangs-Mikrowellenleiter (26) jenseits des Rückkopplungsnetzwerks (8 - 10) beeinflußbar ist, um die Schwingungsfrequenz f abzustimmen.

**11.** Mikrowellen-Oszillator nach einem der vorhergehenden Ansprüche, **dadurch gekennzeichnet, dass** der Eingangs-Mikrowellenleiter (26) gleichspannungsmäßig mit DC-Masse (4) gekoppelt ist, insbesondere über einen Widerstand $R_G$.

**12.** Mikrowellen-Oszillator nach einem der vorhergehenden Ansprüche, **dadurch gekennzeichnet, daß** das Verstärkungselement (2) ein Halbleiterbauelement ist.

**13.** Mikrowellen-Oszillator nach Anspruch 12, **dadurch gekennzeichnet, daß** das Verstärkungselement (2) ein Transistor ist, vorzugsweise ein Hoch- oder Höchstfrequenztransistor.

**14.** Mikrowellen-Oszillator nach Anspruch 13, **dadurch gekennzeichnet, daß** der Transistor (2) in Emitter- bzw. Sourceschaltung geschalten ist, wobei der Basis- bzw. Gateanschluß (5) als Eingang und der Kollektor- bzw. Drainanschluß (6) als Ausgang dient.

**15.** Mikrowellen-Oszillator nach Anspruch 14, **dadurch gekennzeichnet, daß** an dem Sourceanschluß (3) eine Gegenkopplungsimpedanz nach DC-Masse (4) angeschlossen ist, bspw. ein Gegenkopplungswiderstand $R_s$ und/oder eine Gegenkopplungskapazität $C_s$.

**16.** Mikrowellen-Oszillator nach Anspruch 15, **dadurch gekennzeichnet, dass** die Gegenkopplungskapazität $C_s$ (u.a.) eine großflächige Leiterfläche (14) umfaßt, die galvanisch mit dem Sourceanschluß (3) verbunden ist (16) und sich in geringem Abstand parallel zu einer Massepotential (4) führenden Leiterbahnebene (19) erstreckt (Multilayer-Anordnung).

**17.** Mikrowellen-Oszillator nach Anspruch 16, **dadurch gekennzeichnet, dass** die großflächige Leiterfläche (14) der Gegenkopplungskapazität $C_s$ als metallische Grundplatte Bestandteil der Mikrowellenleiter-Strukturen (23 - 27) ist.

FIG. 1

FIG. 2

FIG. 3

FIG. 4